# EUROPÄISCHE PATENTANMELDUNG

(11) **EP 1 868 421 A2**
(43) Veröffentlichungstag der Anmeldung: **19.12.2007**
(21) Anmeldenummer: 07011556.3
(22) Anmeldetag: 13.06.2007
(51) Int. Cl.: H05B 33/22, H05B 33/28

(54) **Elektrolumineszierendes folienförmiges Leuchtelement**

(30) Priorität: 14.06.2006 DE 102006028216
(71) Anmelder: Schefenacker Vision Systems Germany GmbH, 71409 Schwaikheim (DE)
(72) Erfinder: Covasala, Alexander, 73728 Esslingen (DE); Beutelschiess, Klaus, 73265 Dettingen (DE); Fink, Thorsten, 73095 Albershausen (DE)
(74) Vertreter: Kaufmann, Ursula Josefine

(57) **Zusammenfassung**

Die Erfindung betrifft ein elektrolumineszierendes Leuchtelement, insbesondere ein folienartiges Leuchtelement, mit einer Lichtaustrittsfläche (34) zur Lichtabgabe aus einer auf einem Träger (12) angeordneten Leuchtpigmentschicht (16). Gemäß der Erfindung weist das Leuchtelement (10) eine elektrisch leitfähige Umhüllung (30) auf.

## Beschreibung

Die Erfindung betrifft ein elektrolumineszierendes Leuchtelement, insbesondere ein folienartiges Leuchtelement, nach dem Oberbegriffe des Anspruchs 1.

Leuchtelemente auf der Basis von Elektrolumineszenz sind bekannt. Neben Leuchtdioden, so genannten LEDs, sind auch großflächige Leuchtelemente auf starren und auch auf flexiblen Trägern bekannt. In der Praxis haben sich auf der Basis der Dickschichttechnologie hergestellte Folienelemente bewährt, die mit Wechselspannungsfeldern angeregt werden. Hier sind Leuchtpigmente in einem transparenten, organischen oder keramischen Bindemittel eingebettet. Die Leuchtpigmente bestehen üblicherweise aus binären Verbindungen. Das elektrische Feld wird über strukturierte Elektroden zugeführt, von denen die Frontelektrode, aus der die Elektrolumineszenzstrahlung austritt, aus einer transparenten, elektrisch leitfähigen Materialschicht besteht, beispielsweise einer sehr dünnen Metallschicht oder einem transparenten Halbleiter wie Indiumoxid oder Indiumzinnoxid (ITO). Die Rückelektrode besteht aus einer leitenden Metallschicht. Die zwischen Front- und Rückelektrode angeordnete Leuchtpigmentschicht, gegebenenfalls mit einer zusätzlichen Isolationsschicht, bildet in Verbindung mit ihrem Einbettungsmittel das Dielektrikum eines Kondensators, weshalb verschiedentlich auch die Bezeichnung "Leuchtkondensator" verwendet wird. Die Leuchtelemente sind nichtlineare Bauelemente, deren Parameter eine Funktion von angelegter Spannung und Frequenz sind und auch von Umgebungsbedingungen wie Feuchtigkeit und Temperatur abhängen.

Häufig ist die transparente Elektrode ein mit Indiumoxid oder Indiumzinnoxid beschichteter Kunststoff (z.B. Polyester), wobei der Kunststoff als Träger dient. Das Leuchtpigment kann beispielsweise aus Zinksulfid bestehen, das durch verschiedene Metalle wie Au, Ag, Cu, Ga oder Mn dotiert ist. Die Farbe des emittierten Lichtes und die Leitfähigkeit der Leuchtpigmentschicht werden durch Stärke und Zusammensetzung der Dotierung bestimmt. Durch Variation der Dotierung können Farbtöne von Blau bis Gelb, entsprechend einer Wellenlänge von etwa 480 nm bis 580 nm, und durch Mischen der Dotierungsstoffe daraus resultierende Mischfarben, beispielsweise die Mischfarbe weiß, erzielt werden. Eine auf diese Leuchtpigmentschicht aufgebrachte Isolationsschicht, beispielsweise aus Bariumtitanat, wirkt gleichzeitig als Reflektor. Darauf wird anschließend die Rückelektrode, etwa Aluminium, Kohlenstoff oder Silberlack, appliziert. Da Zinksulfid stark hygroskopisch ist, wird eine Kapselung vorgesehen, die aus intensiv Wasser abstoßendem Material besteht. Es gibt aber bereits Pigmentgrundstoffe, bei dem die Zinksulfidmoleküle mikrogekapselt sind, so dass die hygroskopischen Eigenschaften weniger hervortreten. Durch den größeren Molekülabstand bedingt ist die Leuchtdichte etwas geringer und nicht ganz so homogen. Derartige folienartige Leuchtelemente sind schneidbar, extrem dünn, hochflexibel und kostengünstig. Ein Einlaminieren ist nicht mehr unbedingt nötig, erhöht jedoch den Feuchtigkeitsschutz zusätzlich.

Elektrolumineszierende Leuchtelemente werden in der Regel mit relativ hohen Wechselspannungen bis 300 Volt und typischen Frequenzen zwischen 200 Hz und 3 kHz betrieben. Spannung und Frequenz können die Leuchtstärke bzw. die Leuchtdichte beeinflussen. Dabei wirken sowohl das Leuchtelement als auch die Zuleitungen als Sendeantenne, welche eine elektromagnetische Leistung entsprechend der in das Leuchtelement eingespeisten Wechselspannung abstrahlt. Dies kann insbesondere beim Einsatz der Leuchtelemente im Kraftfahrzeugbereich zu Problemen mit der elektromagnetischen Verträglichkeit (EMV) führen. Um die EMV-Verträglichkeit derartiger Leuchtelemente zu verbessern und die Abstrahlung elektromagnetischer Strahlung zu vermindern oder zu eliminieren, werden aufwändige elektronische Filter und Inverter eingesetzt.

Aufgabe der Erfindung ist es, ein elektrolumineszierendes Leuchtelement mit verbesserter EMV-Verträglichkeit anzugeben, das besonders für den Einsatz in Kraftfahrzeugen geeignet ist.

Die Aufgabe wird erfindungsgemäß durch die Merkmale der unabhängigen Ansprüche gelöst. Günstige Ausgestaltungen und Vorteile der Erfindung ergeben sich aus den weiteren Ansprüchen und der Beschreibung.

Ein erfindungsgemäßes elektrolumineszierendes Leuchtelement weist eine Lichtaustrittsfläche zur Lichtabgabe aus einer Leuchtpigmentschicht auf und ist mit einer elektrisch leitfähigen Umhüllung versehen. Die Umhüllung umgibt das Leuchtelement wenigstens bereichsweise. Das Leuchtelement ist insbesondere ein folienartiges Leuchtelement mit einer elektrolumineszierenden Folie. Die elektrisch leitfähige Umhüllung bildet eine Schirmung gegen das Abstrahlen von elektromagnetischer Strahlung.

Die elektrische Leitfähigkeit liegt vorzugsweise im Bereich metallischer Leitfähigkeit oder im Bereich der elektrischen Leitfähigkeit hochdotierter Halbleiter. Das Leuchtelement kann vollständig umhüllt sein, oder auch nur teilweise. Die Umhüllung kann hochflexibel sein oder auch starr. Gegebenenfalls können Bereiche flexibel und andere starr ausgebildet sein. Die Umhüllung kann mit elektrisch leitfähigen Partikeln versetzt oder dotiert sein oder auch elektrisch leitfähig beschichtet sein. Durch die abschirmende Wirkung der Umhüllung kann eine EMV-Schutzbeschaltung von elektronischen Komponenten, die mit dem Leuchtelement verbunden sind, vereinfacht werden oder sogar entfallen. Damit lässt sich beispielsweise ein Wirkungsgrad eines das Leuchtelement mit elektrischer Leistung versorgenden Inverters verbessern und dessen thermische Beanspruchung entsprechend vermindern. Insgesamt sind dadurch Kosteneinsparungen bei der Auslegung des Leuchtelements bzw. der Versorgungselektronik möglich.

Eine vorteilhafte Ausgestaltung ergibt sich, wenn die Umhüllung wenigstens im Bereich der Lichtaustrittsfläche transparent ausgebildet ist. Dadurch bleibt die Funktion des Leuchtelements trotz Umhüllung vorteilhaft unbeeinträchtigt. Im einfachsten Fall kann die Umhüllung in diesem Bereich eine oder mehrere Öffnungen aufweisen. Denkbar ist beispielsweise eine undurchsichtige Umhüllung mit einer oder mehreren entsprechenden Öffnungen an der Lichtaustrittsfläche.

Vorteilhaft kann die Umhüllung wenigstens im Bereich ihrer Lichtaustrittsfläche ein transparentes Material aufweisen, so dass die Lichtemission der Lichtaustrittsfläche unbeeinträchtigt bleibt. Das transparente Material kann über große Flächenbereiche, beispielsweise ganzflächig, auf der Umhüllung angeordnet sein. Zweckmäßigerweise ist die Umhüllung selbst wenigstens in diesen Bereichen aus einem transparenten Material gebildet, beispielsweise aus einer Folie.

Gegebenenfalls kann das transparente Material auf der Lichtaustrittsfläche dünner ausgebildet sein als auf umgebenden Bereichen der Umhüllung. Das transparente Material kann eine Beschichtung in Form einer auf der Umhüllung abgeschiedenen Schicht sein oder durch eine Folie gebildet sein. Eine Schicht kann beispielsweise mit Vakuumdepositionsverfahren wie Aufdampfen oder Sputtern auf die Umhüllung aufgetragen werden. Es kann auch eine freitragende dünne Folie vorgesehen sein, die mit der Umhüllung verbunden ist und, wenigstens bereichsweise, die Lichtaustrittsfläche überdeckt.

Zweckmäßigerweise kann das transparente Material elektrisch leitfähig ausgebildet sein. Bevorzugt ist ein transparenter, vorzugsweise dotierter Halbleiter wie Indiumoxid oder Indiumzinnoxid als Beschichtung vorgesehen, dessen elektrische Leitfähigkeit einer Leitfähigkeit von metallischen Werkstoffen entspricht. Es kann jedoch auch eine sehr dünne metallische Schicht vorgesehen sein, die noch ausreichend transparent ist, jedoch schon eine hinreichende elektrische Leitfähigkeit aufweist.

Zweckmäßigerweise weist die Umhüllung eine Masseverbindung auf, so dass die Abstrahlung von elektromagnetischer Strahlung im Betrieb des Leuchtelements wirksam unterbunden ist. Wird das Leuchtelement als Fahrzeugleuchte eingesetzt, ist eine elektrische Verbindung mit der Fahrzeugmasse als Erdung vorteilhaft.

Besonders effektiv wirkt die Schirmung, wenn die Umhüllung das Leuchtelement im Wesentlichen vollständig umschließen kann. Im Wesentlichen vollständig soll bedeuten, dass Öffnungen für elektrische Zuleitungen vorhanden sind, bzw. zumindest 90% der Fläche des Leuchtelements von der Umhüllung umgeben sind.

Besonders zweckmäßig kann die Umhüllung eine flexible Folie umfassen. Damit ist eine Anpassung der Umhüllung an das Leuchtelement auf einfache Weise möglich. Mit Vorteil kann die Folie aus demselben Material gebildet sein wie eine Trägerfolie des Leuchtelements, auf welcher die Leuchtpigmentschicht angeordnet ist. Dabei kann die Folie wenigstens im Bereich ihrer Lichtaustrittsfläche eine elektrisch leitfähige, transparente Beschichtung aufweisen, so dass ihre Lichtemission unbeeinträchtigt bleibt. Die Folie kann ganzflächig mit der elektrisch leitfähigen Beschichtung beschichtet sein. Die Beschichtung kann vorteilhaft in einem Bandbeschichtungsprozess aufgebracht werden.

Eine elektrische Komponente zur Versorgung des Leuchtelements, insbesondere ein Inverter, kann vorteilhaft innerhalb der Umhüllung angeordnet sein, wodurch dieser von der Schirmwirkung mit erfasst werden kann. Weiterhin sind die Zuleitungen vorteilhaft verkürzt, wodurch deren Antennenwirkung verkleinert ist. Denkbar ist auch, den Inverter auf der Umhüllung anzuordnen. Durch diese Anordnung können wenigstens die Zuleitungen verkürzt werden und so eine Abstrahlung von elektromagnetischer Strahlung im Betrieb des Leuchtelements vermindert werden.

Vorteilhaft kann die Umhüllung selbstklebend ausgebildet sein, was eine leichte Befestigungsweise auf dem Leuchtelement ermöglicht. Die Umhüllung kann vorteilhaft auch als Schutzhülle gegen Umwelteinflüsse, insbesondere gegen Feuchtigkeit dienen. Gegebenenfalls kann dann auf eine Kapselung von feuchteempfindlichen Komponenten des Leuchtelements verzichtet werden. So ist bekannt, dass die Leuchtpigmentschicht durch Feuchtigkeitseinwirkung degradiert.

Besonders bevorzugt ist das Leuchtelement als Fahrzeugleuchte ausgestaltet. Dies kann eine Innenraumleuchte sein oder auch eine Hinterleuchtung von Anzeigen im Fahrzeug. Weiterhin kann das Leuchtelement auch in andere Leuchten des Fahrzeugs integriert sein.

Weitere Vorteile und Einzelheiten der Erfindung werden im Folgenden anhand eines in der Zeichnung beschriebenen bevorzugten Ausführungsbeispiels näher erläutert, ohne auf dieses Ausführungsbeispiel beschränkt zu sein.

Es zeigen:
- Fig. 1: schematisch ein elektrolumineszierendes Leuchtelement im Schnitt;
- Fig. 2: ein Detail einer bevorzugten Umhüllung für ein erfindungsgemäßes Leuchtelement; und
- Fig. 3: schematisch ein elektrolumineszierendes Leuchtelement im Schnitt mit einem in einer Umhüllung angeordneten elektronischen Bauelement.

In den Figuren sind gleich bleibende oder gleich wirkende Elemente grundsätzlich mit denselben Bezugszeichen beziffert.

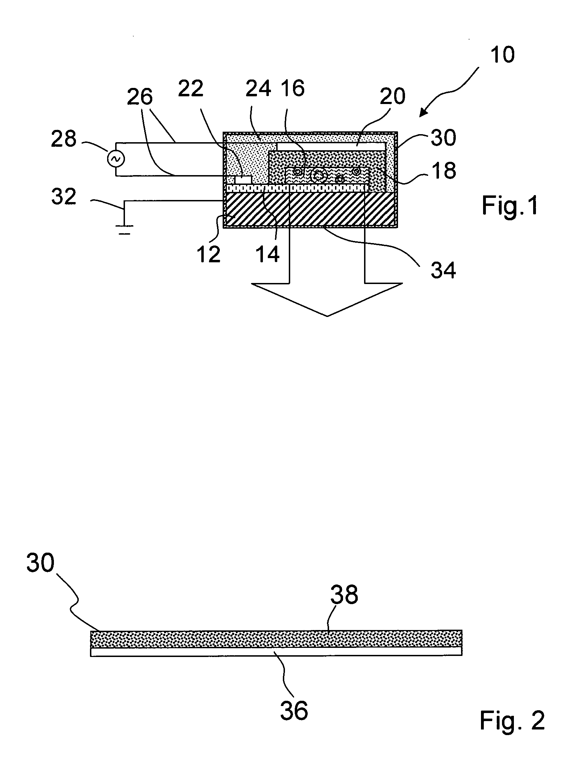

Figur 1 zeigt zur Erläuterung der Erfindung schematisch ein bevorzugtes elektrolumineszierendes Leuchtelement 10 im Schnitt. Erfindungsgemäß umgibt eine flexible, leitfähige Umhüllung 30 das Leuchtelement 10. Die Umhüllung 30 wirkt wegen ihrer hohen elektrischen Leitfähigkeit auf als Faradayscher Käfig und verhindert eine Abstrahlung von elektromagnetischer Strahlung von dem Leuchtelement 10 in die Umgebung. Bevorzugt ist das Leuchtelement 10 als elektrolumineszierende Folienleuchtelement ausgebildet. Solche Folienleuchtelemente können vorteilhaft als flächige Leuchten eingesetzt werden. Bevorzugt ist ein solches Leuchtelement 10 als Fahrzeugleuchte eingesetzt, etwa im Innenraum oder an oder in einer Außenleuchte, beispielsweise auch in Kombination mit anderen Leuchtmitteln wie Leuchtdioden oder Glühlampen.

Der innere Aufbau des Leuchtelements 10 ist weitgehend konventionell. Auf einem Träger 12, der starr oder als Folie ausgebildet sein kann, insbesondere als PET-Folie (PET = Polyethylenterephthalat), ist eine transparente Elektrodenschicht 14 als Frontelektrode angeordnet. Die Elektrodenschicht 14 ist über eine elektrische Leitstruktur 22 elektrisch kontaktierbar. Die Elektrodenschicht 14 ist vorzugsweise aus dotiertem Indiumoxid oder Indiumzinnoxid gebildet.

Die Elektrodenschicht 14 trägt eine Leuchtpigmentschicht 16, die für die elektrolumineszierenden Eigenschaften des Leuchtelements 10 verantwortlich ist, die von einer Isolationsschicht 18, beispielsweise aus Bariumtitanat, umgeben ist. Auf die Isolationsschicht 18 folgt eine Elektrodenschicht 20 als Rückelektrode. Die Elektrodenschicht 20 mit der Isolationsschicht 18 und der Leuchtpigmentschicht 16, die beispielsweise ZnS aufweist, sowie die Leitungsstruktur 22 können mit einer Schutzschicht 24 gekapselt sein. Die Schutzschicht 24 kann aus einem geeigneten Schutzlack und/oder einer einseitig oder zweiseitig selbstklebenden Schutzfolie aus PP (Polypropylen) oder PET bestehen. Im letzteren Fall kann die Schutzschicht 24 sogar Bestandteil der Umhüllung 30 sein.

Die Umhüllung 30 ist wenigstens im Bereich der Lichtaustrittsfläche 34 transparent ausgebildet. Der Pfeil deutet die Lichtaustrittsrichtung des Leuchtelements 10 an.

Die Elektrodenschicht 20 und die elektrische Leitungsstruktur 22 sind über Zuleitungen 26 mit einer Stromversorgung 28 verbunden, welche eine Wechselspannung mit einer gewünschten Frequenz zur Versorgung des Leuchtelements 10 zur Verfügung stellt.

Die Umhüllung 30 weist eine Masseverbindung 32 auf, die im Fall eines Einsatzes als Fahrzeugleuchte bevorzugt die Fahrzeugmasse ist.

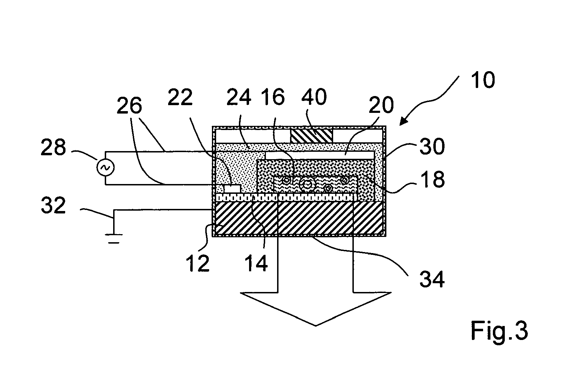

Figur 3 zeigt eine bevorzugte Ausgestaltung der Erfindung, bei der eine elektronische Komponente 40, vorzugsweise ein Inverter, zur Versorgung des Leuchtelements 10 innerhalb einer Umhüllung 30 angeordnet ist. Die sonstigen Komponenten entsprechen denen in Figur 1, auf die zur Erläuterung verwiesen wird, um unnötige Wiederholungen zu vermeiden.

Das Leuchtelement 10 kann mit einer Wechselspannung mit einem Effektivwert von ca. 50-300 V_{eff} und 100-2000 Hz betrieben werden. Diese Wechselspannung liefert vorzugsweise ein spezieller Inverter, teilweise auch Konverter genannt, der auf das jeweilige Leuchtelement 10 abgestimmt ist. Hierbei werden die elektrischen Eigenschaften und die Abmessungen des Leuchtelements 10 berücksichtigt. Eingangsseitig liegt am Inverter beispielsweise eine Bordnetzspannung eines Fahrzeugs an, ausgangsseitig wird dem elektrolumineszierenden Leuchtelement 10 das Wechselspannungssignal zur Verfügung gestellt.

Figur 2 erläutert einige Details einer bevorzugten Umhüllung 30. Ein transparentes Material in Form einer transparenten und elektrisch leitfähigen Beschichtung 38 ist auf einer hochflexiblen Folie 36 angeordnet.

Vorzugsweise liegt die Leitfähigkeit der Beschichtung im Bereich derer von metallischen Werkstoffen. Sinnvollerweise ist der spezifische Widerstand kleiner als 1·10⁻⁶ Ωm. Günstig sind beispielsweise dotierte transparente Halbleiter wie Indiumoxid oder Indiumzinnoxid.

Auf ihrer von der Beschichtung 38 abgewandten Seite ist die Folie 36 mit einem Kleber versehen und bildet so eine selbstklebende Umhüllung 30. Die Folie 36 ist beispielsweise aus demselben Material gebildet wie der Träger 12 des Leuchtelements 10. Mit der Umhüllung 30 kann ein Eindringen von Feuchtigkeit, aber auch eine unerwünschte Einwirkung von UV-Strahlen auf die empfindliche Leuchtpigmentschicht 16, vermindert werden. Durch die selbstklebenden Eigenschaften der Umhüllung 30 kann diese mit an sich bekannten geeigneten Laminiertechniken einfach auf ein folienförmiges Leuchtelement 10 aufbringen.

### Bezugszeichenliste

- 10: Leuchtelement
- 12: Träger
- 14: Elektrodenschicht
- 16: Leuchtpigmentschicht
- 18: Isolationsschicht
- 20: Elektrodenschicht
- 22: elektrische Leitungsstruktur
- 24: Schutzschicht
- 26: Spannungsversorgung
- 28: AC-Versorgung
- 30: Umhüllung
- 32: Masseverbindung
- 34: Lichtaustrittsfläche
- 36: Folie
- 38: Beschichtung
- 40: elektrische Komponente

## Patentansprüche

1. Elektrolumineszierendes Leuchtelement, insbesondere folienartiges Leuchtelement, mit einer Lichtaustrittsfläche (34) zur Lichtabgabe aus einer auf einem Träger (12) angeordneten Leuchtpigmentschicht (16), **gekennzeichnet durch** eine elektrisch leitfähige Umhüllung (30).

2. Leuchtelement nach Anspruch 1, **dadurch gekennzeichnet, dass** die Umhüllung (30) wenigstens im Bereich der Lichtaustrittsfläche (34) transparent ausgebildet ist.

3. Leuchtelement nach Anspruch 1 oder 2, **dadurch gekennzeichnet, dass** die Umhüllung (30) im Bereich der Lichtaustrittsfläche (34) ein transparentes Material (38) aufweist.

4. Leuchtelement nach Anspruch 3, **dadurch gekennzeichnet, dass** das transparente Material (38) elektrisch leitfähig ist.

5. Leuchtelement nach einem der vorhergehenden Ansprüche, **dadurch gekennzeichnet, dass** die Umhüllung (30) das Leuchtelement (10) im Wesentlichen vollständig umschließt.

6. Leuchtelement nach einem der vorhergehenden Ansprüche, **dadurch gekennzeichnet, dass** die Umhüllung (30) eine flexible Folie (36) umfasst.

7. Leuchtelement nach einem der vorhergehenden Ansprüche, **dadurch gekennzeichnet, dass** eine elektrische Komponente (40) zur Spannungsversorgung innerhalb der Umhüllung (30) angeordnet ist.

8. Leuchtelement nach einem der vorhergehenden Ansprüche, **dadurch gekennzeichnet, dass** eine elektrische Komponente (40) zur Spannungsversorgung auf der Umhüllung (30) angeordnet ist.

9. Leuchtelement nach einem der vorhergehenden Ansprüche, **dadurch gekennzeichnet, dass** die Umhüllung (30) selbstklebend ausgebildet ist.

10. Leuchtelement nach einem der vorhergehenden Ansprüche, **dadurch gekennzeichnet, dass** die Umhüllung (30) eine Masseverbindung (32) aufweist.

11. Leuchtelement nach einem der vorhergehenden Ansprüche, **gekennzeichnet durch** eine Ausgestaltung als Fahrzeugleuchte.
